# EUROPEAN PATENT APPLICATION

(11) **EP 4 135 008 A2**
(43) Date of publication of application: **15.02.2023**
(21) Application number: 22197139.3
(22) Date of filing: 22.09.2022
(51) Int. Cl.: H01L 21/20

(54) **A HEMT**

(30) Priority: 22.07.2021 GB 202110537
(71) Applicant: IQE plc, Cardiff CF3 0LW (GB)
(72) Inventor: KAESS, Felix, Cardiff, CF3 0LW (GB); LABOUTIN, Oleg, Cardiff, CF3 0LW (GB); KAO, Chen-Kai, Cardiff, CF3 0LW (GB)
(74) Representative: Yeomans, Victoria Jane Anora

(57) **Abstract**

A high electron mobility transistor 22 comprising a nucleation layer 14 having a first lattice constant, a back-barrier layer 24 having a second lattice constant and a stress management layer 26 having a third lattice constant which is larger than both first and second lattice constants. The stress management layer 26 compensates some or all of the stress due to the lattice mismatch between the nucleation layer 14 and back barrier layer 24 so that the resulting structure experiences less bow and warp.

## Description

A high electron mobility transistor having a stress management layer, particularly but not exclusively suitable for 5G base station applications.

High electron mobility transistors (HEMTs) are well known for wireless communication applications. A HEMT acts as a high speed digital on-off switch with high gain. As demand increases there is a desire for HEMTs grown on larger substrate wafers which exposes a greater tendency for bow and warp which can cause difficulties in subsequent manufacturing and handling, and introduce non-uniformity between devices grown on a wafer.

The HEMT of the present invention seeks to address this problem by provision of a stress management layer.

The present invention provides a high electron mobility transistor comprising: a silicon carbide substrate; a nucleation layer having a first lattice constant; a back barrier layer having a second lattice constant; a channel layer; a front barrier layer which forms a two-dimensional electron gas (2DEG) in the channel layer; and a stress management layer having a third lattice constant which is larger than the first lattice constant and the second lattice constant, wherein the stress management layer is positioned between the nucleation layer and the back barrier layer. The second lattice constant is the maximum lattice constant in the back barrier layer. The third lattice constant is the minimum lattice constant in the stress management layer.

The stress management layer having a larger lattice constant than the nucleation layer and back barrier layer is advantageous because it results in a more planar upper surface for growth of the subsequent layers and thus a more uniform wafer. Advantageously a more uniform wafer results in uniformity between HEMT devices from a single wafer so performance is more predictable. Furthermore, reducing bow and/or warp of the wafer results in higher yield (useable devices) from a given size of substrate wafer.

The stress management layer may be depleted of charge carriers. The stress management layer may be depleted of all charge carriers. Thus it may be partially depleted or fully depleted of charge carriers. Advantageous such a layer does not introduce electrical conductivity into the device and so no parasitic channel is created.

The back barrier layer may comprise aluminium gallium nitride or indium aluminium nitride. Advantageously this layer provides a carrier confinement for the 2DEG of the HEMT and minimizes parasitic charge carrier leakage.

At least a portion of the back barrier layer may comprise AlₓGa₁₋ₓN where x is less than 4%. Conventional AIGaN HEMTs generally have Al content around 4%. At least a portion of the back barrier layer may comprise AlₓGa₁₋ₓN where x is less than 1%. Advantageously such a low Al content is suitable for broader frequency bands.

The back barrier layer may comprise a graded composition of AlₓGa₁₋ₓN. Advantageously the lattice constant may be adjusted through the layer to better match the adjacent layers. Advantageously defects are thus reduced. The composition of the back barrier layer may be graded stepwise or continuously.

In the composition x may be maximal adjacent the stress management layer and x may be lower adjacent the channel layer than adjacent the stress management layer. Thus the Al content may reduce through the layer in the vertical, growth direction. Alternatively x may be maximal adjacent the channel layer and x may be lower adjacent the stress management layer than adjacent the channel layer. Thus the Al content may increase through the layer in the vertical, growth direction. Alternatively x may be maximal at an intermediate point through the layer and be lower adjacent both the stress management layer and the channel layer. The value of x may be the same adjacent the channel layer and stress management layer or may be different. Advantageously the lattice mismatch between layers can be managed by grading the composition of the back barrier layer.

The stress management layer may comprise InₓAl_{y}Ga_{1-x-y}N where x>0 for y>0. Advantageously the lattice constant of such compositions can be greater than the lattice constant of the back barrier layer and the nucleation layer by selection of x and y, which reduces the stress in the back barrier layer and device. The stress management layer may comprise GaN, that is x=y=0. Advantageously GaN has a larger lattice constant than AIN, a typical material for the nucleation layer, and a larger lattice constant than AIGaN with low Al content.

The stress management layer may be between 1nm and 200nm thick in the growth direction, that is vertically or in the direction perpendicular to the plane of the substrate. The stress management layer may be 1nm to 20nm thick. It may be 10nm to 20nm thick. The back barrier layer may be between 0.1µm and 10µm thick in the growth direction, that is vertically or in the direction perpendicular to the plane of the substrate. Advantageously the stress management layer is thin compared to the back barrier layer. It therefore does not significantly alter the thickness of the HEMT.

The stress management layer may comprise two or more sublayers having different composition and/or constituent elements. The stress management layer may comprise an alternating stack of first and second sublayers, the first and second sublayers having different composition and/or constituent elements from each other. Advantageously the sublayers may be selected to have different lattice constants to reduce the lattice mismatch between the nucleation layer and the stress management layer and between the stress management layer and the back barrier layer whilst gaining the stress alleviation effect.

The front barrier layer may comprise AlInGaN having both a larger band gap than the channel layer and being more polarised. The front barrier layer may comprise AlₓIn_{y}Ga_{1-x-y}N where 0<x≤0.18 and y=4.662^{∗}x. The front barrier layer may comprise AlₓGaN where x≥15%. The composition of the front barrier layer is chosen so that its band gap is larger than that of the channel layer. Advantageously the relatively high Al content forms two-dimensional electron gas (2DEG) in the channel layer.

There may be a spacer layer between the channel layer and the front barrier layer. Advantageously the space layer improves electron mobility in the channel layer.

There may be a cap layer positioned, grown, on the front barrier layer. Advantageously the cap layer stabilises the surface of the HEMT and controls the Schottky barrier height of the gate contact.

The present invention also provides a method of fabricating a high electron mobility transistor comprising steps to: grow a nucleation layer on a silicon carbide substrate; grow a stress management layer on the nucleation layer; grow a back barrier layer on the stress management layer; grow a channel layer on the back barrier layer; and grow a front barrier layer on the channel layer; wherein the stress management layer has a larger lattice constant than the back barrier layer and a larger lattice constant than the nucleation layer.

Advantageously growing a stress management layer on the nucleation layer compensates some or all of the strain caused by the lattice mismatch between the nucleation layer and back barrier layer. Advantageously it may also pre-strain the structure in preparation for growth of the back barrier layer so that the resultant strain after growth of the back barrier layer is lower than would be experienced without the stress management layer. Advantageously the resultant structure has less strain and therefore less bow and warp. Advantageously the wafer grown according to the method is flatter and therefore the HEMTs cut from it are more uniform.

The step to grow the stress management layer may comprise doping the stress management layer. Advantageously this depletes the free charge carriers. The doping may be to a level to fully deplete the stress management layer of all charge carriers.

The method may comprise a further step to grow a spacer layer on the channel layer. The method may comprise a further step to grow a cap layer on the front barrier layer.

Each of the steps of the method may comprise growing a layer by metal-organic vapour phase epitaxy or hydride vapour epitaxy. Each of the steps of the method may comprise growing a layer by molecular beam epitaxy. Advantageously the growth can be controlled precisely.

The present invention will be more fully described by way of example with reference to the accompanying drawings, in which:
Figure 1 is a schematic cross-section of a conventional HEMT device;
Figure 2 is a schematic cross-section of a HEMT according to the present invention;
Figure 3 is a schematic cross-section of a stress management layer according to the present invention;
Figure 4 is a schematic cross-section of a HEMT according to the present invention;

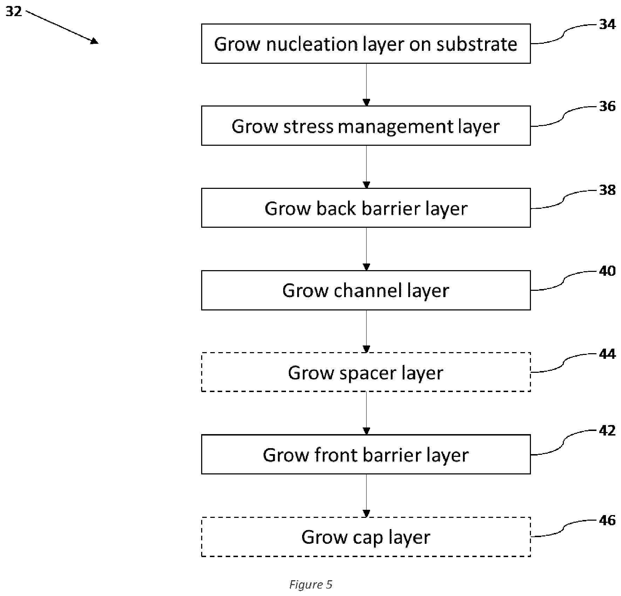

Figure 5 is a flow chart of a method of fabricating a HEMT according to the present invention.

Epitaxy or epitaxial means crystalline growth of material, usually via high temperature deposition. Epitaxy can be effected in a molecular beam epitaxy (MBE) tool in which layers are grown on a heated substrate in an ultra-high vacuum environment. Elemental sources are heated in a furnace and directed towards the substrate without carrier gases. The elemental constituents react at the substrate surface to create a deposited layer. Each layer is allowed to reach its lowest energy state before the next layer is grown so that bonds are formed between the layers. Epitaxy can also be performed in a metal-organic vapour phase epitaxy (MOVPE) tool, also known as a metal-organic chemical vapour deposition (MOCVD) tool. Compound metal-organic and hydride sources are flowed over a heated surface using a carrier gas, typically hydrogen. Epitaxial deposition occurs at much higher pressure than in an MBE tool. The compound constituents are cracked in the gas phase and then reacted at the surface to grow layers of desired composition.

Deposition means the depositing of a layer on another layer or substrate. It encompasses epitaxy, chemical vapour deposition (CVD), powder bed deposition and other known techniques to deposit material in a layer.

A compound material comprising one or more materials from group III of the periodic table with one or more materials from group V is known as a III-V material. The compounds have a 1:1 combination of group III and group V regardless of the number of elements from each group. Subscripts in chemical symbols of compounds refer to the proportion of that element within that group. Thus Al_{0.25}GaAs means the group III part comprises 25% Al, and thus 75% Ga, whilst the group V part comprises 100% As.

Crystalline means a material or layer with a single crystal orientation. In epitaxial growth or deposition subsequent layers with the same or similar lattice constant follow the registry of the previous crystalline layer and therefore grow with the same crystal orientation. In-plane is used herein to mean parallel to the surface of the substrate; out-of-plane is used to mean perpendicular to the surface of the substrate.

Throughout this disclosure, as will be understood by the skilled reader, crystal orientation <100> means the face of a cubic crystal structure and encompasses [100], [010] and [001] orientations using the Miller indices. Similarly <0001> encompasses [0001] and [000-1] except if the material polarity is critical. Integer multiples of any one or more of the indices are equivalent to the unitary version of the index. For example, (222) is equivalent to, the same as, (111).

Substrate means a planar wafer on which subsequent layers may be deposited or grown. A substrate may be formed of a single element or a compound material, and may be doped or undoped. For example, common substrates include silicon (Si), gallium arsenide (GaAs), silicon germanium (SiGe), silicon germanium tin (SiGeSn), indium phosphide (InP), and gallium antimonide (GaSb).

A substrate may be on-axis, that is where the growth surface aligns with a crystal plane. For example it has <100> crystal orientation. References herein to a substrate in a given orientation also encompass a substrate which is miscut by up to 20° towards another crystallographic direction, for example a (100) substrate miscut towards the (111) plane.

Vertical or out of plane means in the growth direction; lateral or in-plane means parallel to the substrate surface and perpendicular to the growth direction.

Doping means that a layer or material contains a small impurity concentration of another element (dopant) which donates (donor) or extracts (acceptor) charge carriers from the parent material and therefore alters the conductivity. Charge carriers may be electrons or holes. A doped material with extra electrons is called n-type whilst a doped material with extra holes (fewer electrons) is called p-type.

Lattice matched means that two crystalline layers have the same, or similar, lattice spacing and so the second layer will tend to grow isomorphically on the first layer. Lattice constant is the unstrained lattice spacing of the crystalline unit cell. Lattice coincident means that a crystalline layer has a lattice constant which is, or is close to, an integer multiple of the previous layer so that the atoms can be in registry with the previous layer. Lattice mismatch is where the lattice constants of two adjacent layers are neither lattice matched nor lattice coincident. Such mismatch introduces elastic strain into the structure, particularly the second layer, as the second layer adopts the in-plane lattice spacing of the first layer. The strain is compressive where the second layer has a larger lattice constant and tensile where the second layer has a smaller lattice constant.

Where the strain is too great the structure relaxes to minimise energy through defect generation, typically dislocations, known as slip, or additional interstitial bonds, each of which allows the layer to revert towards its lattice constant. The strain may be too great due to a large lattice mismatch or due to an accumulation of small mismatches over many layers. A relaxed layer is known as metamorphic, incoherent, incommensurate or relaxed, which terms are also commonly interchangeable.

A pseudomorphic system is one in which a single-crystal thin layer overlies a single-crystal substrate and where the layer and substrate have similar crystal structures and nearly identical lattice constants. In a pseudomorphic structure the in-plane lattice spacing of the thin layer adopts the in-plane lattice constant of the substrate and is therefore elastically strained, either compressively where the layer has a larger lattice spacing than the substrate or tensilely where the layer has a smaller lattice spacing than the substrate. A pseudomorphic structure is not constrained in the out-of-plane direction and so the lattice spacing of the thin layer in this direction may change to accommodate the strain generated by the mismatch between lattice spacing. The thin layer may alternatively be described as "coherent", "commensurate", "strained" or "unrelaxed", which terms are often used interchangeably. In a pseudomorphic structure all the layers adopt the lattice spacing of the substrate in their respective in-plane lattice spacing.

A layer may be monolithic, that is comprising bulk material throughout. Alternatively it may be porous for some or all of its thickness. A porous layer includes air or vacuum pores, with the porosity defined as the proportion of the area which is occupied by the pores rather than the bulk material. The porosity can vary through the thickness of the layer. For example, the layer may be porous in one or more sublayer. The layer may include an upper portion which is porous with a lower portion that is non-porous. Alternatively the layer may include one or more discrete, non-continuous portions (domains) that are porous with the remainder being non-porous (with bulk material properties). The portions may be non-continuous within the plane of a sublayer and/or through the thickness of the layer (horizontally and/or vertically in the sense of the growth direction). The portions may be distributed in a regular array or irregular pattern across the layer, and/or through it. The porosity may be constant or variable within the porous regions. Where the porosity is variable it may be linearly varied through the thickness, or may be varied according to a different function such as quadratic, logarithmic or a step function.

A fully depleted porous layer means a layer in which there are no charge carriers.

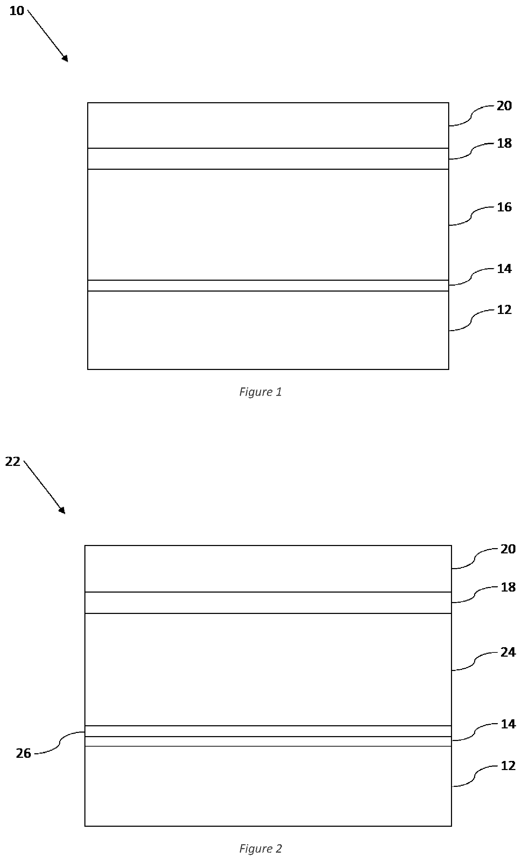

Figure 1 shows a cross-sectional schematic of a conventional HEMT 10. A substrate 12 may be formed of silicon (Si), silicon carbide (SiC), or another suitable material. A nucleation layer 14 is provided over the substrate 12. The nucleation layer 14 is a thin layer, of the order of 10nm thick, which enables heteroepitaxy by providing a template for subsequent layers.

A relatively thick buffer layer 16 is provided over the nucleation layer 14. The buffer layer 16 may comprise gallium nitride (GaN), aluminium gallium nitride (AlGaN) or another suitable material. Above the buffer layer 16 is a channel layer 18 in which electrons flow when the HEMT 10 is in use.

Finally a front barrier layer 20 is provided over the channel layer 18. The front barrier layer 20 is configured to have a band gap offset and different polarisation to the channel layer 18 which gives high electron mobility in the adjacent channel layer 18. The front barrier layer 20 typically comprises aluminium gallium nitride (AlGaN) or a quaternary compound such as InAIGaN. Where the aluminium content is high, greater than about 15% (atomic percentage of group III part of compound) and more commonly greater than 20% for example, the front barrier layer 20 forms a two-dimensional electron gas (2DEG), a gas of free carriers (electrons), in the channel layer 18 which .

The invention will now be described more particularly with reference to Figure 2. A HEMT 22 according to the present invention is preferably formed by epitaxial growth to obtain high quality, low defect, crystalline layers. The HEMT 22 comprises a substrate 12, nucleation layer 14, stress management layer 26, back barrier layer 24, channel layer 18 and front barrier layer 20.

The substrate 12 is formed of SiC. It may be a circular wafer with diameter of 4" (100mm) or greater.

A nucleation layer 14 is grown on the substrate 12. The nucleation layer 14 may be 1-500nm thick and comprise AIN. The nucleation layer 14 therefore has a first lattice constant of 3.111 Angstroms (Å). The nucleation layer 14 is provided to enable heteroepitaxial growth of subsequent layers, that is growth of dissimilar materials, on the substrate 12. Alternatively the nucleation layer 14 may comprise another material such as boron nitride (BN), boron aluminium nitride (Bal)N or aluminium silicon carbon nitride (AlSiCN) as known to the skilled reader. The nucleation layer 14 may be the same as in the conventional HEMT 10 shown in Figure 1.

The HEMT 22 of the present invention has a back barrier layer 24 grown over the nucleation layer 12 instead of the buffer layer 16 of the conventional HEMT 10. The back barrier layer 24 is a relatively thick layer, for example 0.1-10µm. The back barrier layer 24 comprises a compound of aluminium gallium nitride (AlGaN) with a low concentration of Al. For example, the AlₓGa₁₋ₓN may have x in the range 4-8%, less than 4%, around 3%, around 2%, around 1%, or above 0.1%. The back barrier layer 24 therefore has a second lattice constant in the range 3.183-3.189Angstroms (Å). The second lattice constant is larger than the first lattice constant.

Alternatively the back barrier layer 24 may have a graded composition in which the aluminium content reduces in the growth direction, away from the substrate 12. The Al content is maximal closest to the substrate 12 and nucleation layer 14, with content as described in the previous paragraph. The grading may be stepwise or continuous. If continuous, the Al content may have a linear or non-linear profile from a maximal value closest to the substrate 12 to a minimal value closest to the next layer, the channel layer 18. If stepwise, the steps may be of equal or unequal size in the growth direction and may each be a constant reduction in Al content or the amount of reduction may be different between different steps. In a graded configuration, there may be one or more region, sublayer, in which the Al content does not reduce so that a grading profile of Al content against layer thickness exhibits one or more plateaux. The Al concentration may reduce to substantially zero adjacent to the channel layer 18. Alternatively the Al content may increase in the growth direction. The grading may be stepwise or continuous as described, mutatis mutandis. In a further alternative the Al content may increase and then decrease in the growth direction so that it is maximal at a location intermediate the thickness of the back barrier layer 24.

The back barrier layer 24 is relatively thick and has an appreciable level of stress due to the lattice mismatch between the first lattice constant of the nucleation layer 14 and the second lattice constant of the back barrier layer 24. The lattice mismatch is small enough, due to the low concentration of Al, that stress is generated but relaxation does not occur. Thus the stress accumulates with layer thickness. The back barrier layer 24 is pseudomorphic because the stress does not relax. Since the second lattice constant is larger than the first lattice constant this stress causes the structure to bow and warp into a convex shape. Bow may be defined as the deviation of the centre point of the median surface of an unclamped wafer from a reference plane. Warp is defined as the sum of the maximum positive and negative deviations from the best fit plane (when the wafer is unclamped).

Alternatively the back barrier layer 24 may comprise indium aluminium nitride (InAIN). The lattice constant of In_{0.17}Al_{0.83}N is 3.185Å.

A stress management layer 26 is grown over the nucleation layer 14, before the back barrier layer 24. The stress management layer 26 may be grown directly on the nucleation layer 14 with no intervening layers. The back barrier layer 24 may be grown directly on the stress management layer 26 with no intervening layers. The stress management layer 26 has a third lattice constant which is larger than the second lattice constant of the back barrier layer 24. The third lattice constant is therefore also larger than the first lattice constant of the nucleation layer 14. The stress management layer 26 may be partially strained, due to the lattice mismatch with the nucleation layer 14, or it may be fully relaxed. The lattice mismatch between the stress management layer 26 and the nucleation layer 14 has the opposite sign to the lattice mismatch between the stress management layer 26 and the back barrier layer 24. For example, the lattice mismatches produce compressive strain and tensile strain respectively. Thus the stress management layer 26 compensates some or all of the lattice mismatch stress between the nucleation layer 14 and back barrier layer 24 so that the resulting structure experiences less bow and warp. Consequently the top surface of the back barrier layer 24 is flatter than would be the case if no stress management layer 26 were included. Beneficially the stress management layer 26 therefore improves uniformity of the material and device characteristics across the wafer, especially across larger diameter wafers. It also reduces the number of defects associated with stress. Furthermore it improves the mechanical robustness of the HEMT wafer, improves wafer handling in a device process line and improves device reliability. The handling is improved because a curved wafer is difficult to manipulate using tweezers, for example, and can be strained to slot into a cassette. The device reliability is improved because all the devices grown on a wafer experience the same growth conditions, such as temperature and dopant concentration, and get the same thickness of layers deposited because the wafer contacts the heated substrate holder uniformly. Thus there is less defectiveness in the wafer.

The stress management layer 26 is thin, for example 1 to 200nm thick. It may be 1 to 20nm thick or 10-20nm thick. It may comprise pure (undoped) GaN. Alternatively it may comprise InₓGa₁₋ₓN where x is greater than zero and is chosen so that the third lattice constant is greater than the second lattice constant of the back barrier layer 24. Alternatively it may comprise InₓAl_{y}Ga_{1-x-y}N where x and y are each greater than zero and chosen so that the third lattice constant of the stress management layer 26 is larger than the lattice constant of the back barrier layer 24.

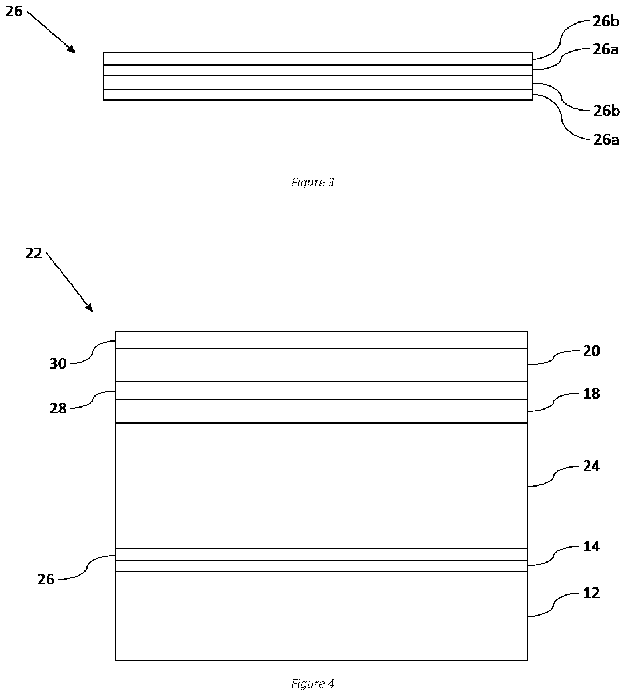

The stress management layer 26 may comprise two or more sublayers 26a, 26b. The sublayers 26a, 26b may comprise a different composition from each other. For example, GaN and InGaN, GaN and AlInGaN, or InGaN and AlInGaN, or GaN and AIN. The two sublayers 26a, 26b may be in an alternating stack of two or more sublayers 26a, 26b, for example the second sublayer 26b sandwiched between two first sublayers 26a, or alternating first sublayers 26a and second sublayers 26b as shown in Figure 3.

The stress management layer 26 may have a narrower band gap than the nucleation layer 14 and back barrier layer 24. It can be undoped, unintentionally doped with some impurities, or doped with impurities to control electrical characteristics. The impurities can be C, Fe, Mg or other impurities compensating or trapping any free charge carriers present in the stress management layer 26. Thus, the stress management layer 26 is at least partially depleted of charge carriers. The stress management layer 26 may be depleted of all carriers; that is, fully depleted. This means that minimal or no electrical conductivity is created in the layer. Beneficially the stress management layer 26 does not affect the device performance despite having a narrower band gap than the back barrier layer 24, which would otherwise create a second electrically conductive, or parasitic, channel in the device.

Referring back to Figure 2, a channel layer 18 is grown over the back barrier layer 24. The channel layer 18 may be grown directly on the back barrier layer 24. The channel layer 18 comprises undoped GaN which is conductive. Electrons flow through the channel layer 18 when the HEMT 22 is switched on during operation. The channel layer 18 is 10-500nm thick. The channel layer 18 may be substantially the same as in the conventional HEMT 10.

Finally a front barrier layer 20 is grown over the channel layer 18. The front barrier layer 20 may be substantially the same as in the conventional HEMT 10. It comprises AlₓGa₁₋ₓN where x is greater than 15%, often greater than 20% and may be as high as 100%, being AIN. The front barrier layer 20 may be around 20nm thick in the growth direction. The front barrier layer 20 provides the 2DEG in the channel layer 18 which increases the mobility of electrons through the device.

Alternatively the front barrier layer 20 may comprise InAIGaN. The InAIGaN composition must be such that it has larger bandgap than GaN, which forms the channel layer. Furthermore, the composition must be chosen so that it is more polarised than GaN. Compositions in the range approximately 0<x≤0.18 and y=4.662^{∗}x meet these criteria.

Optionally the front barrier layer 20 may include a spacer 28 as shown in Figure 4. The spacer 28 may comprise pure aluminium nitride (AIN). The spacer 28 acts to separate the channel layer 18 and front barrier layer 20 which improves the electron mobility in the channel layer 18 by providing a more abrupt transition.

Optionally the front barrier layer 20 may additionally or alternatively include a cap layer 30. The cap layer 30 may comprise GaN. The cap layer 30 stabilises the surface of the HEMT 22 and controls the Schottky barrier height of the gate contact.

Further device layers may be grown, deposited or bonded onto the top of the HEMT 22 as is conventional. For example, a gate, source and drain may be provided. In some circumstances providing these additional components may require etching away of some of the described layers. For example it may be beneficial to position one or more of the gate, source and drain recessed into the front barrier layer 20 so that it or they are nearer to the channel layer 18. A diamond layer may be grown or deposited which provides thermal dissipation. Additionally or alternatively a silicon nitride (SiN) passivation layer may be provided over the cap.

The present invention also provides a method 32 of fabricating a HEMT 22 comprising growing successive layers over a SiC substrate 12. The growth may be epitaxial growth in a molecular beam epitaxy (MBE), metal-organic vapour phase epitaxy (MOVPE), hydride vapour phase epitaxy (HVPE) or other epitaxial growth reactor. In a first step 34 a nucleation layer 14 is grown on a SiC substrate 12. In a second step 36 a stress management layer 26 is grown on the nucleation layer 14. In a third step 38 a back barrier layer 24 is grown on the stress management layer. In a fourth step 40 a channel layer 18 is grown on the back barrier layer 24. In a fifth step 42 a front barrier layer 20 is grown on the channel layer 18.

Each layer is crystalline with the crystal registry set by the crystal orientation of the previous layer, and consequently of the substrate 12. Epitaxial growth is particularly well suited to forming high quality, low defect, crystalline layers.

The stress management layer 26 has a lattice constant that is larger than the lattice constant of the back barrier layer 24, as described above, in order to compensate the lattice mismatch between the nucleation layer 14 and the back barrier layer 24. The stress management layer 26 therefore reduces bow and/or warp of the back barrier layer 24. Consequently the method 32 results in more uniform material characteristics across the wafer, particularly for large diameter wafers, a more reliable HEMT 22 and greater yield from each wafer.

The thickness, composition and conductivity (level of impurities) of the stress management layer 26 can all be precisely controlled during the epitaxial growth.

The method 32 may include an optional step 44 to grow a spacer layer 28 on the channel layer 18. The method 32 is therefore modified to grow the front barrier layer 20 on the spacer layer 28. The space layer 28 may form part of the front barrier layer 20.

The method 32 may include a further optional step 46 to grow a cap layer 30 on the front barrier layer 20. The cap layer 30 may form part of the front barrier layer.

The third step 38 to grow back barrier layer 24 may include growing a graded layer as described above. The grading may comprise varying the proportions of Al and Ga in a continuous or step-wise fashion.

The method 32 may be performed in a single operation in one reactor. Each step may follow immediately after the previous step without the need to change tools or reload the wafers. Thus there is minimal possibility of introducing defects or damage.

Alternatively the method 32 may be performed in two or more operations. The first operation may comprise the first, second and third steps 34, 36, 38. The layer stack may then be transferred to another reactor, for example from MBE to MOVPE, from MOVPE to MBE, or between sites or companies. Then the subsequent layers may be grown in the fourth, fifth and optional steps 40, 42, 44, 46.

Advantageously the stress management layer 26 of the present invention does not introduce a requirement for doping in any of the layers to form the 2DEG. The crystal orientation of the GaN is [0001] (wurtzite), which is polar. This means that 2DEG is generated without impurity doping with the consequence that ionised impurity scattering is minimise because there are no dopants with which electrons could collide.

The HEMT 22 of the present invention finds particular utility as a power amplifier for time domain duplexing at high frequency bandwidth. Thus it is suitable for high speed and/or high frequency 5G applications in a wireless base station or handset. Such applications require higher signal power which makes GaN-based systems particularly attractive since they have higher power density, higher breakdown voltage and are thermally stable.

Advantageously the HEMT 22 of the present invention, particularly the stress management layer 26, enables mass production of larger diameter wafers because the bow and/or warp caused by lattice mismatch is substantially reduced or eliminated. Thus wafers of 4" (100mm) or larger can be processed with high yield.

Advantageously the stress management layer 26 may be just a few nanometres thick and therefore the HEMT 22 is not significantly thicker than the conventional HEMT 10.

## Claims

1. A high electron mobility transistor (22) comprising:
• a silicon carbide substrate (12);
• a nucleation layer (14) having a first lattice constant;
• a back barrier layer (24) having a second lattice constant, wherein the second lattice constant is the maximum lattice constant in the back barrier layer (24);
• a channel layer (18);
• a front barrier layer (20) which forms a two-dimensional electron gas in the channel layer (18); and
• a stress management layer (26) having a third lattice constant which is larger than the first lattice constant and the second lattice constant, wherein the stress management layer (26) is positioned between the nucleation layer (14) and the back barrier layer (24), and wherein the third lattice constant is the minimum lattice constant in the stress management layer (26).

2. A high electron mobility transistor (22) as claimed in claim 1 wherein the stress management layer (26) is depleted of charge carriers.

3. A high electron mobility transistor (22) as claimed in claim 1 or claim 2 wherein the stress management layer (26) is depleted of all charge carriers.

4. A high electron mobility transistor (22) as claimed in any preceding claim wherein the back barrier layer (24) comprises aluminium-gallium nitride or indium aluminium nitride.

5. A high electron mobility transistor (22) as claimed in claim 4 wherein at least a portion of the back barrier layer (24) comprises AlₓGa₁₋ₓN where x is less than 4%.

6. A high electron mobility transistor (22) as claimed in claim 4 or claim 5 wherein at least a portion of the back barrier layer (24) comprises AlₓGa₁₋ₓN where x is approximately 1%.

7. A high electron mobility transistor (22) as claimed in any of claims 4 to 6 wherein the back barrier layer (24) comprises a graded composition of AlₓGa₁₋ₓN.

8. A high electron mobility transition (22) as claimed in claim 7 wherein:
• x is maximal adjacent the stress management layer (26); and
• x is lower adjacent the channel layer (18) than adjacent the stress management layer (26).

9. A high electron mobility transistor (22) as claimed in any preceding claim wherein the stress management layer (26) comprises InₓAl_{y}Ga_{1-x-y}N where x>0 for y>0.

10. A high electron mobility transistor (22) as claimed in any preceding claim wherein the stress management layer (26) is between 1nm and 200nm thick in the growth direction.

11. A high electron mobility transistor (22) as claimed in any preceding claim wherein the back barrier layer (24) is between 0.1µm and 10µm thick in the growth direction.

12. A high electron mobility transistor (22) as claimed in any preceding claim wherein the stress management layer (26) comprises two or more sublayers (26a, 26b) having different composition and/or constituent elements.

13. A high electron mobility transistor (22) as claimed in claim 12 wherein the stress management layer (26) comprises an alternating stack of first and second sublayers (26a, 26b), the first and second sublayers (26qa, 26b) having different composition and/or constituent elements from each other.

14. A high electron mobility transistor (22) as claimed in any preceding claim wherein the front barrier layer (20) comprises AlₓGa_{1-y}N where x≥15%.

15. A high electron mobility transistor (22) as claimed in any preceding claim further comprising a spacer layer (28) between the channel layer (18) and the front barrier layer (20).

16. A high electron mobility transistor (22) as claimed in any preceding claim further comprising a cap layer (30) positioned on the front barrier layer (20).

17. A method of fabricating a high electron mobility transistor (22) comprising steps to:
• grow a nucleation layer (14) on a silicon carbide substrate (12);
• grow a stress management layer (26) on the nucleation layer (14);
• grow a back barrier layer (24) on the stress management layer (26);
• grow a channel layer (18) on the back barrier layer (24); and
• grow a front barrier layer (20) on the channel layer (18);
wherein the stress management layer (26) has a larger lattice constant than the back barrier layer (24) and a larger lattice constant than the nucleation layer (14).

18. A method of fabricating a high electron mobility transistor (22) as claimed in claim 17 wherein the step to grow a stress management layer (26) comprises doping the stress management layer (26).

19. A method of fabricating a high electron mobility transistor (22) as claimed in claim 17 or 18 further comprising a step to grow a spacer layer (28) on the channel layer (18).

20. A method of fabricating a high electron mobility transistor (22) as claimed in claim 17 or claim 18 further comprising a step to grow a cap layer (30) on the front barrier layer (20).

21. A method of fabricating a high electron mobility transistor (22) as claimed in any of claims 17 to 20 wherein each of the steps of growing a layer comprises epitaxial growth by molecular beam epitaxy or metal-organic vapour phase epitaxy.
